# FASCICULE DE BREVET EUROPEEN

(11) **EP 0 718 634 B1**
(45) Date de publication et mention de la délivrance du brevet: **22.08.2001**
(21) Numéro de dépôt: 95410143.2
(22) Date de dépôt: 18.12.1995
(51) Int. Cl.: G01R 19/00

(54) **Circuit bipolaire de fourniture de tension extremum**
Bipolar-Schaltung zur Lieferung einer Extremspannung
Bipolar circuit for generating a voltage extremum

(30) Priorité: 21.12.1994 FR 9415671
(43) Date de publication de la demande: 26.06.1996
(73) Titulaire: STMicroelectronics S.A., 94250 Gentilly (FR)
(72) Inventeur: van Zalinge, Klaas, F-38240 Meylan (FR)
(74) Mandataire: de Beaumont, Michel

(56) Documents cités:
- EP-A- 0 584 402
- GB-A- 1 241 454
- US-A- 3 348 072
- US-A- 3 678 513
- PATENT ABSTRACTS OF JAPAN vol. 11 no. 212 (E-522) ,9 Juillet 1987 & JP-A-62 034416 (VICTOR CO OF JAPAN LTD) 14 Février 1987,
- IBM TECHNICAL DISCLOSURE BULLETIN, vol. 27, no. 5, Octobre 1984 NEW YORK US, pages 2908-2910, 'Maximum and Minimum Voltage Detection'
- PATENT ABSTRACTS OF JAPAN vol. 16 no. 453 (E-1267) ,21 Septembre 1992 & JP-A-04 158687 (TOSHIBA CORP) 1 Juin 1992,

## Description

La présente invention concerne un circuit permettant de fournir la tension la plus élevée ou la tension la plus basse (tension extremum) de plusieurs tensions d'entrée.

Un tel circuit sert le plus souvent à générer une tension de forme complexe à l'aide de plusieurs tensions de forme simple. En particulier, en télévision, un tel circuit sert à donner une forme particulière aux transitions des signaux de chrominance, qui améliore l'impression visuelle des images.

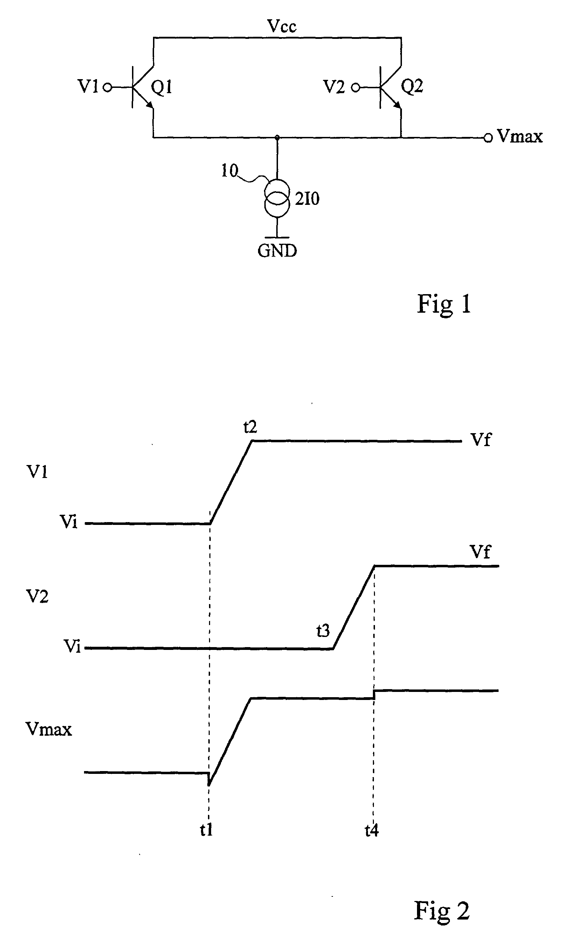

La figure 1 représente un circuit classique de fourniture de la tension la plus élevée Vmax de deux tensions d'entrée V1 et V2. Ce circuit comprend deux transistors NPN Q1 et Q2 recevant respectivement sur leurs bases les tensions V1 et V2. Les collecteurs de ces transistors sont reliés à un potentiel d'alimentation haut Vcc et les émetteurs fournissent la tension maximale Vmax et sont reliés à la masse GND par une source de courant 10 délivrant un courant constant 2I0.

Lorsqu'une des tensions, par exemple V1, est supérieure à l'autre, V2, le transistor correspondant Q1 se comporte en suiveur et sa tension d'émetteur Vmax suit l'évolution de la tension V1. La jonction base-émetteur de l'autre transistor Q2 se trouve polarisée en inverse, ce qui bloque ce transistor. La totalité du courant 2I0 passe alors dans le transistor Q1.

Si les tensions V1 et V2 sont égales, les transistors Q1 et Q2 sont tous les deux conducteurs. Le courant de la source 10 est réparti entre les transistors Q1 et Q2, c'est-à-dire que chacun de ces transistors est alors traversé par un courant I0.

En reliant en parallèle sur les transistors Q1 et Q2 d'autres transistors, on réalise un circuit de fourniture de la tension la plus élevée de trois tensions d'entrée ou plus.

La figure 2 est destinée à illustrer un inconvénient du circuit de la figure 1. Cette figure 2 représente un exemple d'évolution des tensions V1 et V2 et de la valeur correspondante de la sortie Vmax. La figure 2 est schématique et représente des transitions de tension abruptes. En pratique, ces transitions sont progressives.

Jusqu'à l'instant t1, les tensions V1 et V2 sont à une même valeur initiale Vi. A l'instant t1, la tension V1 croît jusqu'à un instant t2 où elle atteint une valeur finale Vf. La tension V2 croît à partir d'un instant t3 jusqu'à un instant t4 où cette tension V2 atteint la valeur Vf.

Jusqu'à l'instant t1, la tension Vmax est à une tension égale à Vi diminuée de la tension base-émetteur Vbe des transistors Q1 et Q2. Les transistors Q1 et Q2 sont tous deux conducteurs et traversés chacun par un courant I0 (le courant de la source 10 est uniformément réparti entre les transistors Q1 et Q2).

Entre les instants t1 et t4, la tension V1 est supérieure à la tension V2. Alors, le transistor Q2 est bloqué et le transistor Q1 est le seul à conduire. La totalité du courant, 2I0, de la source 10 traverse le transistor Q1, ce qui augmente la tension Vbe du transistor Q1. Comme la tension Vmax suit l'évolution de la tension V1, diminuée de la tension Vbe du transistor Q1, elle est décalée vers le bas, comme cela est représenté. Ce saut que subit la tension de sortie Vmax est proportionnel au logarithme népérien du rapport entre le courant maximal du transistor concerné (Q1) et son courant minimal non nul. Dans le pire cas, ce rapport est égal au nombre de tensions d'entrée à traiter. Dans l'exemple de la figure 2, on traite deux tensions, et le saut est d'environ 20 millivolts. Ce saut, de valeur constante, est d'autant plus perturbateur que le niveau des signaux d'entrée est faible. Le brevet US-A-3 348 072 décrit un circuit générateur d'extremum selon le préambule de la revendication 1. Il comporte en outre pour chaque tension d'entrée un moyen amplificateur fournissant le courant requis à la sortie commune afin d'éviter la non-linéarité en sortie due à la variation de V_{be} en fonction du courant dans les premiers transistors bipolaires d'entrée.

Un objet de la présente invention est de prévoir un circuit de fourniture de tension extremum dont la sortie ne subit aucun saut lorsqu'au moins deux tensions d'entrée passent entre un état égal et un état différent.

Cet object est atteint selon l'invention à l'aide de cellules associées respectivement aux tensions d'entrée, qui assurent que chaque transistor qui fournit la tension extremum sur une ligne de sortie commune, soit parcouru par un courant constant. Ce résultat est obtenu en prévoyant que chaque cellule ne fournit aucun courant sur la ligne commune lorsque son transistor est bloqué.

La présente invention vise plus particulièrement une cellule comprenant un premier transistor bipolaire dont la base reçoit la tension d'entrée et dont l'émetteur est relié à une sortie commune fournissant la tension extremum ; une première source de courant de polarisation de l'émetteur du premier transistor ; et un commutateur pour déconnecter la première source du premier transistor lorsque ce transistor est bloqué.

Selon un mode de réalisation de la présente invention, la cellule comprend un deuxième transistor du même type que le premier, relié en parallèle par sa base et son collecteur sur le premier transistor, et dont l'émetteur est relié à un potentiel d'alimentation par une deuxième source de courant de valeur moitié de celui de la première source de courant. Un troisième transistor du même type que le premier a son collecteur relié à l'émetteur du premier transistor, sa base reliée à l'émetteur du deuxième transistor, et son émetteur relié au potentiel d'alimentation par la première source de courant. Un quatrième transistor, forme avec le troisième un étage différentiel, et a sa base reliée à l'émetteur du premier transistor.

Les objet, caractéristiques et avantages de la présente invention seront exposés plus en détail dans la description suivante du mode de réalisation particulier, faite à titre non-limitatif à l'aide des figures jointes parmi lesquelles :
la figure 1, précédemment décrite, représente un circuit classique de fourniture de la tension la plus élevée de plusieurs tensions d'entrée ;
la figure 2 représente un exemple d'évolution de tensions du circuit de la figure 1 ;
la figure 3 représente un mode de réalisation de cellule selon l'invention permettant de réaliser un circuit de fourniture de tension extremum.

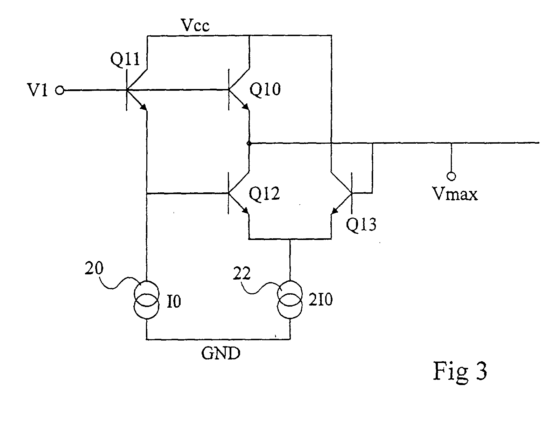

Une cellule du type de la figure 3 est associée à chaque tension d'entrée à traiter pour réaliser un circuit de fourniture de la tension la plus faible ou, dans les modes de réalisation décrits, la tension la plus élevée des tensions d'entrée. Pour réaliser un circuit de fourniture de la tension la plus faible, il suffira de réaliser les cellules de manière symétrique en inversant le type des transistors.

Dans le mode de réalisation de la figure 3, la cellule comprend un transistor NPN Q10 recevant sur sa base la tension d'entrée V1 associée à la cellule. Le collecteur du transistor Q10 est relié à un potentiel d'alimentation haut Vcc et son émetteur est relié à une ligne Vmax, commune à toutes les cellules du circuit, qui fournit la tension extremum, la tension maximale dans cet exemple. La tension V1 est également fournie à la base d'un transistor NPN Q11 relié en parallèle par sa base et son collecteur sur le transistor Q10. L'émetteur du transistor Q11 est relié à la masse GND par une source de courant 20 délivrant un courant I0.

L'émetteur du transistor Q10 est relié au collecteur d'un transistor NPN Q12 dont la base reçoit la tension d'émetteur du transistor Q11 et dont l'émetteur est relié à la masse par une source de courant 22 délivrant un courant 2I0. Un transistor NPN Q13 forme avec le transistor Q12 un étage différentiel. Ce transistor Q13 a son émetteur relié à l'émetteur du transistor Q12, sa base reliée à l'émetteur du transistor Q10, et son collecteur relié à la tension Vcc.

Si la tension V1 est supérieure aux autres tensions d'entrée (non représentées), le transistor Q10 se comporte en suiveur et la tension Vmax est égale à la tension V1 diminuée de la tension base-émetteur Vbe0 du transistor Q10. Le transistor Q11 se comporte également en suiveur et il apparaît sur la base du transistor Q12 la tension V1 diminuée de la tension base-émetteur Vbe1 du transistor Q11. Ainsi, l'étage différentiel Q12, Q13 reçoit deux tensions pratiquement égales, ce qui provoque une répartition uniforme du courant de la source 22 dans les transistors Q12 et Q13. Il en résulte qu'un courant IO traverse le transistor Q10, qui est le même courant que celui traversant le transistor Q11. Ainsi, les tensions base-émetteur des transistors Q10 et Q11 sont égales, ce qui ne fait que confirmer l'état d'équilibre de l'étage Q12, Q13.

Cet état de la cellule de la figure 3 n'est pas modifié par le fait que les autres tensions d'entrée deviennent égales à la tension V1, car la tension de sortie Vmax, qui détermine l'équilibre de l'étage différentiel Q12, Q13, n'est pas modifiée.

Si maintenant la tension V1 devient inférieure aux autres tensions d'entrée, le transistor Q12 de l'étage différentiel reçoit sur sa base une tension inférieure à la tension de base Vmax du transistor Q13. L'étage différentiel est déséquilibré, et tout le courant de la source 22 passe par le transistor Q13. Ainsi, le courant que ne peut plus conduire le transistor Q10 n'est pas fourni par la ligne Vmax à l'homologue du transistor Q10 d'une autre cellule.

L'étage différentiel Q12, Q13 se comporte comme un commutateur qui empêche la fourniture d'un courant (I0) sur la ligne commune Vmax dès que le transistor Q10 ne peut plus conduire ce courant.

## Revendications

1. Circuit de fourniture de la tension extremum (Vmax) de plusieurs tensions d'entrée (V1, V2...), comprenant, pour chaque tension d'entrée (V1), une cellule comprenant:
- un premier transistor bipolaire (Q10) dont la base reçoit la tension d'entrée et dont l'émetteur est relié à une sortie commune fournissant la tension extremum (Vmax) ;
- une première source de courant (22) de polarisation de l'émetteur du premier transistor ;
caractérisé en ce chaque cellule comprend un commutateur (Q12, Q13) pour déconnecter la première source du premier transistor lorsque ce transistor est bloqué.

2. Circuit selon la revendication 1, caractérisé en ce chaque cellule comprend :
- un deuxième transistor (Q11) du même type que le premier, relié en parallèle par sa base et son collecteur sur le premier transistor, et dont l'émetteur est relié à un potentiel d'alimentation (GND) par une deuxième source de courant (20) de valeur moitié de celui de la première source de courant ; et en ce que chaque commutateur comprend:
- un troisième transistor (Q12) du même type que le premier, dont le collecteur est relié à l'émetteur du premier transistor, dont la base est reliée à l'émetteur du deuxième transistor, et dont l'émetteur est relié au potentiel d'alimentation par la première source de courant (22) ; et
- un quatrième transistor (Q13), formant avec le troisième un étage différentiel, dont la base est reliée à l'émetteur du premier transistor.

3. Circuit selon la revendication 2, caractérisé en ce que la tension extremum est la tension maximale, les transistors étant des transistors NPN.

4. Circuit selon la revendication 2, caractérisé en ce que la tension extremum est la tension minimale, les transistors étant des transistors PNP.

## Patentansprüche

1. Eine Schaltung zum Liefern der Extremspannung (Vmax) aus mehreren Eingangsspannungen (V1, V2, ...), die für jede Eingangsspannung (V1) eine Zelle umfaßt, die folgendes aufweist:
- einen ersten Bipolartransistor (Q10) dessen Basis die Eingangsspannung empfängt und dessen Emitter mit einem gemeinsamen Ausgang verbunden ist, der die Extremspannung (Vmax) liefert;
- eine erste Stromquelle (22) zum Vorspannen des Emitters des ersten Transistors;
dadurch gekennzeichnet, daß jede Zelle einen Schalter (Q12, Q13) umfaßt zum Abtrennen der ersten Quelle von dem ersten Transistor, wenn der erste Transistor blockiert ist.

2. Eine Schaltung gemäß Anspruch 1, dadurch gekennzeichnet, daß sie folgendes umfaßt:
- einen zweiten Transistor (Q11) der gleichen Bauart wie der erste, der parallel durch seine Basis und seinen Kollektor mit dem ersten Transistor verbunden ist, und dessen Emitter mit einer Versorgungsspannung (GND) durch eine zweite Stromquelle (20) mit einem Wert von der Hälfte dessen der ersten Stromquelle verbunden ist; und dadurch, daß jeder Schalter folgendes aufweist:
- einen dritten Transistor (Q12) der gleichen Bauart wie der erste, dessen Kollektor mit dem Emitter des ersten Transistors verbunden ist, dessen Basis mit dem Emitter des zweiten Transistors verbunden ist, und dessen Emitter durch die erste Stromquelle (22) mit der Versorgungsspannung verbunden ist; und
- einen vierten Transistor (Q13), der mit dem dritten eine Differenzierstufe bildet, deren Basis mit dem Emitter des ersten Transistors verbunden ist.

3. Eine Schaltung gemäß Anspruch 2, dadurch gekennzeichnet, daß die Extremspannung die Maximalspannung ist, wobei die Transistoren NPN-Transistoren sind.

4. Eine Schaltung gemäß Anspruch 2, dadurch gekennzeichnet, daß die Extremspannung die Minimalspannung ist, wobei die Transistoren PNP-Transistoren sind.

## Claims

1. A circuit for supplying the extremum voltage (Vmax) among several input voltages (V1, V2...), including, for each input voltage (V1), a cell comprising:
- a first bipolar transistor (Q10), whose base receives the input voltage and whose emitter is connected to a common output supplying the extremum voltage (Vmax);
- a first current source (22) for biasing the emitter of the first transistor;
characterized in that each cell includes a switch (Q12, Q13) for disconnecting the first source from the first transistor when the first transistor is blocked.

2. A circuit according to claim 1, characterized in that it includes:
- a second transistor (Q11) of the same type as the first one, connected in parallel by its base and its collector to the first transistor, and the emitter of which is connected to a supply voltage (GND) through a second current source (20) with a value of half that of the first current source; and in that each switch comprises:
- a third transistor (Q12) of the same type as the first one, the collector of which is connected to the emitter of the first transistor, the base of which is connected to the emitter of the second transistor, and the emitter of which is connected to the supply voltage through the first current source (22); and
- a fourth transistor (Q13), forming with the third one a differential stage, the base of which is connected to the emitter of the first transistor.

3. A circuit according to claim 2, characterized in that the extremum voltage is the maximum voltage, the transistors being NPN transistors.

4. A circuit according to claim 2, characterized in that the extremum voltage is the minimum voltage, the transistors being PNP transistors.
